(19) Europäisches Patentamt
European Patent Office
Office européen des brevets

(11) **EP 2 017 965 A1**

(12) **EUROPEAN PATENT APPLICATION**

(43) Date of publication:
**21.01.2009 Bulletin 2009/04**

(51) Int Cl.:
***H03M 13/39*** *(2006.01)*

(21) Application number: **08158167.0**

(22) Date of filing: **12.06.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **14.06.2007 US 763009**

(71) Applicant: **QUANTUM CORPORATION**
**San Jose, CA 95110 (US)**

(72) Inventor: **Feller, Marc**
**Long Beach, CA 90803 (US)**

(74) Representative: **Ljungberg, Robert**
**Baker Botts (UK) LLP**
**41 Lothbury**
**London EC2R 7HF (GB)**

(54) **Sliding map detector for partial response channels**

(57) An estimator of the noiseless output of a noisy partial response channel is described. The estimator operates recursively. In each iteration, the estimator processes a window of the N most recently received noisy channel outputs to compare subsequence metrics for all possible channel output subsequences of length N, and selects a noiseless subsequence with maximal posterior probability. One noiseless sample of the selected subsequence is output as an estimate of one of the channel outputs.

Figure 3.

Description

## TECHNICAL FIELD

The present disclosure relates generally to detection over noisy communication channels with inter-symbol interference, and more specifically, to the estimation of noiseless channel outputs in the presence of noise.

## BACKGROUND

In a time-dispersive communication channel, such as a magnetic storage channel, it is advantageous to filter the channel to provide an equalized channel response which, when synchronously sampled in the absence of noise, provides nonzero integer-valued samples over a limited span. When the span of the equalized response is more than one symbol period in response to a single input, the responses of sequential inputs interfere with one another, and the equalized channel is referred to in the literature as a partial response channel. Partial response channel models such as dicode partial response, class-IV partial response (PR4), or extended class-IV partial response (EPR4) are of particular interest in magnetic recording.

When the output of a partial response channel is synchronously sampled, the response to a given channel input is dependent on the current input and previous channel inputs whose nonzero response is within the interference span of the equalized channel. Each output sample is corrupted by additive noise, which is often assumed to be Gaussian.

For purposes of the following discussion, it is convenient to associate a sequence of symbols, such as $\{u_0, u_1, u_2,...\}$ with the corresponding *D*-transform of the sequence,

$$U(D) = \sum_{i=0}^{\infty} u_i D^i \ ,$$

where $u_i$ is the $i^{th}$ symbol in the sequence and D is the unit delay operator.

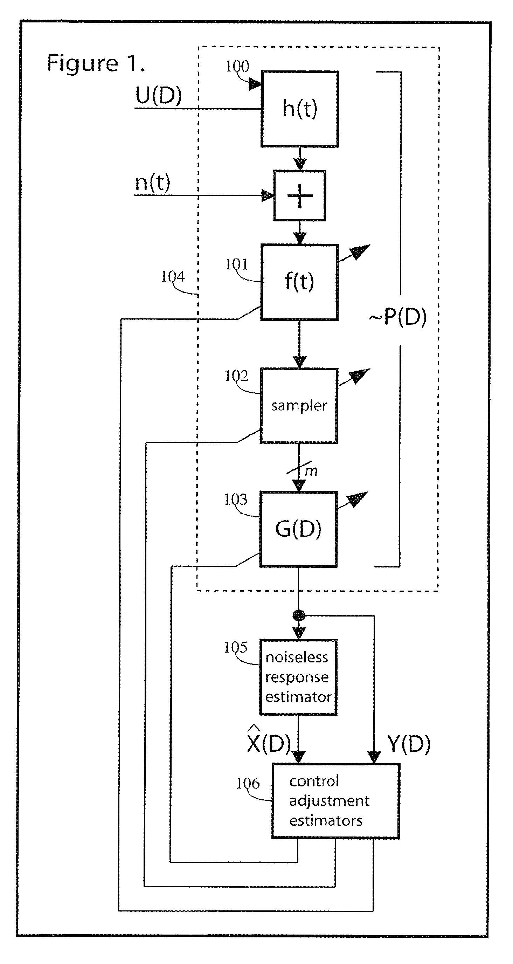

Fig. 1 is a simplified diagram of a typical partial response receiver for magnetic recording channels. The sequence of binary user inputs U(D) is the input to a magnetic channel 100 with time domain dibit response *h(t)*. The output of the channel is corrupted by wideband, additive noise. Analog lowpass filter 101 band-limits the received signal to prevent aliasing in sampler 102. The sampler may be either an analog-to-digital converter (A-to-D), or may alternatively be an analog sample-and-hold circuit. In a typical A-to-D sampler, the range of noisy channel outputs is linearly quantized to m bits, where m is six or more. The stream of samples enters equalizer 103, which is typically a finite-impulse-response (FIR) filter. In addition, equalizer 103 may optionally be adaptive to refine the channel response.

In an ideal system with perfect gain, equalization, timing, and without noise, the combined response of 104 is the desired system partial response polynomial, *P(D)*. The output of the ideal noiseless partial response channel is given by *X(D)= U(D)P(D)*. A partial response polynomial of the form $P(D) = (1- D)(1 + D)^R$ is commonly utilized in a magnetic recording system, where R is a non-negative integer. When R = 0, *P(D)* = 1 - D, and the system is known as a dicode partial response channel. For a PR4 system, R = 1 and the partial response polynomial is $P(D) = 1 - D^2$; for EPR4, R = 2 and $P(D) = 1 + D - D^2 - D^3$ .

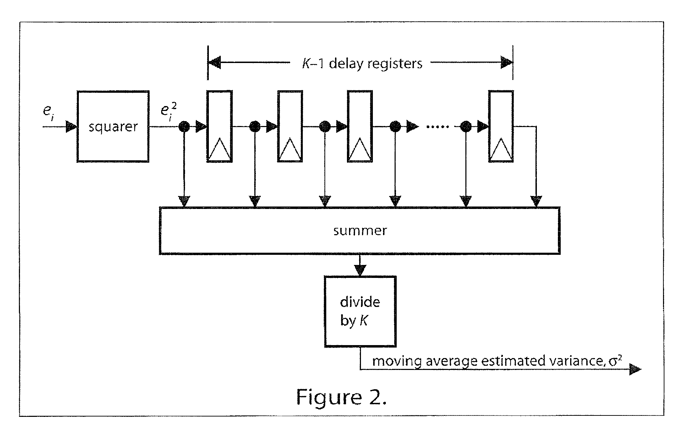

In a real system, the output of the partial response channel is *Y(D) =X(D) + E(D),* where the various channel imperfections observed at the $i^{th}$ output of the system are lumped into an error term, $e_i$. Under the assumption that channel imperfections are due to conditions which vary slowly as compared to the bit rate of the system, the average channel quality over the most recent observed span of *K* samples may be monitored. One such method of monitoring channel quality obtains an estimate of the average error variance over a span of *K* samples in a moving average estimator as shown in Figure 2.

In the typical receiver of Fig. 1, sampling errors are minimized with decision-directed control loops, which adjust for variations in channel amplitude, timing phase error in sampling, and a misadjusted equalizer. In particular, the performance of the timing recovery loop is critical. The achievable adaptation rate of these control loops is highly dependent on loop delay, and adaptation rates must be reduced for long delays to maintain control loop stability.

The present disclosure relates to methods of estimating the noiseless response of the partial response channel in a detector. Various prior art detection methods for partial response channels are known in the literature. A typical prior art detector of the noiseless channel output sequence for control loop purposes is a slicer, which relies on the expected integer-valued output of the channel. For example, a dicode channel produces noiseless channel outputs of- 1, 0, and +1 in the absence of noise. By comparing the sampled channel output to set thresholds of-0.5 and 0.5, for example, a slicer is able to make sample-by-sample estimates of the nearest channel output in the set of all possible noiseless channel outputs. The slicer simply regards the partial response channel as a multi-level communication system, where detector decisions at time $i$ are based solely on the observation of channel output at time $i$.

Another prior art detector is known as a Viterbi detector, which performs maximum likelihood sequence estimation using a multi-state detector, where each state represents a possible combination of interfering channel inputs. In order to fully realize the Viterbi detector's gain, the final decisions of the Viterbi detector typically incur a delay several times the interference span of the channel. A slicer-based detector ignores constraints on the sequence of noiseless outputs of the system imposed by properties of the partial response channel, and tends to have a higher estimation error rate than detectors utilizing this sequence information, such as the Viterbi detector.

Decision-directed control loops typically utilize the estimate of the noiseless response of the channel to estimate gain error, timing error, and equalization error. When the slicer-based detector makes erroneous estimates too often, it further corrupts the estimates used to adjust the channel in the decision-directed control loop. In a noisy environment with a high slicer-based detection error rate, timing recovery may be lost, leading to catastrophic error.

Although the Viterbi detector has improved immunity against noise, two salient features of the Viterbi detector make it less typical as a detector in a decision-directed control loop. First, the Viterbi detector typically has long decision delay. The long inherent delay of the Viterbi detector reduces the adaptive performance of a decision-directed control loop. Second, when erroneous tentative decisions are made in the Viterbi detector, internal feedback of state metrics results in final decisions that contain bursts of multiple estimation errors. When decisions of the Viterbi detector are burstily erroneous, these bursts threaten to further corrupt control of the receiver.

In view of the foregoing, a need exists in the art for a general estimation method for the noiseless output of a partial response channel in decision-directed control loops with reasonable delay, with improved immunity against noise, and with limited error propagation.

## SUMMARY

It is an object of the present invention to provide methods, apparatuses and systems directed to estimating the noiseless channel output of a noisy partial response channel with inter-symbol interference. This object can be achieved by features as defined in the independent claims. In each recursion, a sliding window of the N most recent consecutive sampled channel outputs and an estimate of the noise power are processed to estimate one of the noiseless samples within the window, where N spans at least two symbols of the channel's inter-symbol interference.

## BRIEF DESCRIPTION OF THE DRAWINGS

Example embodiments are illustrated in referenced figures of the drawings. It is intended that the embodiments and figures disclosed herein are to be considered illustrative rather than limiting.

Figure 1 is a simplified diagram of a partial response receiver for magnetic recording channels;

Figure 2 is a diagram of a local noise power estimator;

Figure 3 is a diagram of an example branch metric generator for a sliding MAP detector of an embodiment of the present invention, designed for dicode channels with a sliding window length N equal to 2;

Figure 4 is a diagram of the remainder of the example embodiment of a sliding MAP detector for dicode channels;

Figure 5 illustrates three simplifications of Fig. 4, designated as Figs. 5A, B and C;

Figure 6 is a simplified diagram of an example alternative means of implementing the example detector for dicode channels using varying thresholds.

Figure 7 is a diagram of an example branch metric generator for a sliding MAP detector of the present invention, designed for EPR4 channels with a sliding window length N equal to 3;

Figure 8 is a simplified diagram of the complete example EPR4 detector.

## DETAILED DESCRIPTION OF EXAMPLE EMBODIMENTS

The following embodiments and aspects thereof are described and illustrated in conjunction with systems, apparatuses and methods which are meant to be exemplary and illustrative, not limiting in scope. In various embodiments, one or more of the above-described problems have been reduced or eliminated. In addition to the aspects and embodiments described above, further aspects and embodiments will become apparent by reference to the drawings and by study of the following descriptions.

The "sliding MAP detector" of the present disclosure approximately implements a *maximal a posterioiri* (MAP) decision rule to estimate a local subsequence. The decision rule is based on a hypothesis-testing algorithm known in the literature as Bayes' Rule. For a general discussion of Bayes' Rule, see Carl W. Helstrom, Probability and Stochastic Processes for Engineers, ISBN 0-02-353560-1, Macmillan Publishing Company, New York, 1984, pp. 50-51.

The detector uses a sliding window of length N to examine the output of the channel. More specifically, during the $i^{th}$ recursion of the detector algorithm, the metric is computed using the most recent N noisy samples at the partial response channel output, $\{y_{i-N+1}, y_{i-N+2},...,y_i\}$.

The detector's decision rule utilizes pre-determined knowledge of the possible noiseless output subsequences of the partial response channel and the prior probability that each such noiseless output subsequence will occur at the output of the channel.

In one recursion of the detector, the detector associates each hypothetical noiseless output subsequence of length N with a metric, said metric related to the posterior probability of the hypothetical subsequence. The detector considers one hypothetical subsequence with highest posterior probability as a most likely noiseless output subsequence,

$$\{\hat{x}_{i-N+1}, \hat{x}_{i-N+2},...,\hat{x}_i\} \, .$$

The detector issues an estimate of one of the noiseless samples $x_j$ within the most likely output subsequence of samples, denoted $\hat{x}_j$, where $i - N < j < i + 1$.

The detector proceeds in similar fashion in the next recursion, comparing metrics based on the window of samples $\{y_{i-N+2}, y_{i-N+3},...,y_{i+1}\}$, choosing a most likely noiseless output subsequence, and issuing an estimate $\hat{x}_{j+1}$ of $x_{j+1}$.

Note that the output estimate of the present embodiment in recursion $(i + 1)$ does not depend on feedback from the estimate of the detector in recursion $i$. An advantage of the sliding MAP detector is that the effect of a very noisy sample is limited to at most N decisions of the detector. The output subsequence considered most likely in recursion $(i + 1)$ may be inconsistent with the overlapping subsequence considered most likely in recursion $i$. The sliding MAP detector of the present invention may be optionally augmented with a consistency-check circuit as described below.

A subsequence's posterior probability may be defined and approximated in the detector as follows. Let Pr[v] denote the prior probability of a hypothetical $N$-sample noiseless output subsequence $\mathbf{v} = \{v_1, v_2,..., v_N\}$.

Under the hypothesis $H_v$ that

$$\{x_{i-N+1}, x_{i-N+2},...,x_i\} = \{v_1, v_2,...,v_N\} \, ,$$

the $N$-variate joint probability density function of random channel outputs is denoted

$$f_{z_1 z_2 ... z_N}(z_1, z_2,...,z_N \mid v_1, v_2,...,v_N) \, .$$

A conditional probability of observing a particular set of noisy samples $\{y_{i-N+1}, y_{i-N+2},...,y_i\}$ under hypothesis $H_v$ is denoted

$$\Pr[y_{i-N+1}, y_{i-N+2},...,y_i \mid H_v],$$

and it is obtained analytically by performing the $N$-dimensional integration of the probability density function over the appropriate quantization level span of each the observed noisy samples,

$$\Pr[y_{i-N+1}, y_{i-N+2},...,y_i \mid H_v] = \iint ... \int f_{z_1 z_2 ... z_N}(z_1, z_2,...,z_N \mid v_1, v_2,...,v_N) dz_1 dz_2 ... dz_N \, .$$

The posterior probability of hypothesis $H_v$ is defined as

$$P_v = \Pr[\mathbf{v}] \Pr[y_{i-N+1}, y_{i-N+2},...,y_i \mid H_v].$$

It can be shown that the hypothesis $H_v$ is more likely than hypothesis $H_w$ if the posterior probability of hypothesis $H_v$,

$$P_v = \Pr[\mathbf{v}]\Pr[y_{i-N+1}, y_{i-N+2}, ..., y_i \mid H_v]$$

is greater than

$$P_w = \Pr[\mathbf{w}]\Pr[y_{i-N+1}, y_{i-N+2}, ..., y_i \mid H_w],$$

the posterior probability of hypothesis $H_w$. The detector considers all hypotheses corresponding to the N most recent possible noiseless outputs of the partial response channel, and selects a hypothesis with maximal posterior probability using estimates of $\Pr[y_{i-N+1}, y_{i-N+2}, ..., y_i \mid H_v]$.

Simplifying estimation methods of the present invention are elucidated with example sliding map detectors for dicode channels, and a particular embodiment for EPR4 channels. The example sliding map detectors for dicode channels of the present disclosure utilize a sliding window of the two most recently observed samples in the $i^{th}$ recursion, $\{y_{i-1}, y_i\}$. In general, the sliding window may span a greater number of samples, such as the five most recently observed samples, and decisions may be based on all or a subset of the observed samples in the sliding window.

The noiseless output of a dicode channel has the property that, if $x_i$ and $x_{i-1}$ are both nonzero, then $x_i = -x_{i-1}$. Because of this property, the detector need only consider the following seven hypothetical combinations for the values of $x_i$ and $x_i$-1 :

| Hypothesis index | $x_{i-1}$ | $x_i$ |
|---|---|---|
| 0 | 0 | 0 |
| 1 | -1 | 0 |
| 2 | -1 | 1 |
| 3 | 0 | -1 |
| 4 | 0 | 1 |
| 5 | 1 | -1 |
| 6 | 1 | 0 |

The sliding MAP detector uses pre-determined knowledge of noiseless output sequence probabilities. In a coded system, it is assumed that the receiver has knowledge of the transmitter's sequence probabilities. In this example, random input is assumed. A further property of a dicode system with random inputs is that the average probability of the noiseless all-zero output subsequence, $\{0, 0\}$, is 0.25, while the six other noiseless output subsequences each have average probability 0.125.

The noisy outputs of the system are assumed to be random variables with a predictable probability distribution. A probability distribution most commonly assumed is that the noise, n(t) in Fig. 1, is additive white Gaussian noise. If the dominant noise component in a communications system is due to a factor other than Gaussian noise, such as Rayleigh fading, a different probability density function more appropriate for the dominant noise source may be used.

Filtering operations typically introduce correlation between successive samples, coloring the noise at the output of the filter. Under the assumption of Gaussian noise with the hypothesis $H_v : \{x_{i-1}, x_i\} = \{v_1, v_2\}$, the joint conditional probability density function of the two observed random outputs is a bivariate Gaussian probability density function,

$$f_{z_1 z_2}(z_1, z_2 \mid v_1, v_2) = \frac{1}{2\pi\sigma^2\sqrt{1-r^2}} \exp\left[ -\frac{(z_1 - v_1)^2 - 2r(z_1 - v_1)(z_2 - v_2) + (z_2 - v_2)^2}{2(1-r^2)\sigma^2} \right]$$

where r is the correlation coefficient of the random outputs and $\sigma^2$ is the variance of the random outputs. See Carl W. Helstrom, Probability and Stochastic Processes for Engineers, ISBN 0-02-353560-1, Macmillan Publishing Company, New York, 1984, p. 136.

Computation of posterior probabilities is simplified by the additional assumption that the random outputs are uncorrelated and that

$$\Pr[y_{i-1}, y_i \mid H_v] \approx \frac{1}{2\pi\sigma^2} \exp\left[-\frac{(y_{i-1} - v_1)^2 + (y_i - v_2)^2}{2\sigma^2}\right].$$

Using this approximation, it follows that $P_v > P_w$ if and only if

$$2\sigma^2 \ln\left[\Pr[\mathbf{v}]\right] - \left[(y_{i-1} - v_1)^2 + (y_i - v_2)^2\right] > 2\sigma^2 \ln\left[\Pr[\mathbf{w}]\right] - \left[(y_{i-1} - w_1)^2 + (y_i - w_2)^2\right].$$

The common terms $y_i^2$ and $y_{i-1}^2$ on both sides of the above equation can be eliminated to form an equivalent comparison of metrics. Let $M_v$ denote a metric associated with the posterior probability of hypothesis $H_v$. The metric $M_v$ is given by

$$M_v = 2\sigma^2 \ln\left[\Pr[\mathbf{v}]\right] + \sum_{h=1}^{N}\left[2v_h y_{i-N+h} - v_h^2\right].$$

In a partial response receiver, a moving average estimator, such as that shown in Fig. 2, can be used to provide an estimate of the variance, $\sigma^2$, in calculating $M_v$.

When two hypothesis have equal prior sequence probabilities, $\Pr[v] = \Pr[w]$, it suffices to compare sub-metrics,

$$SM_v = \sum_{h=1}^{N}\left[2v_h y_{i-N+h} - v_h^2\right] = \sum_{h=1}^{N} B(v_h, y_{i-N+h}),$$

where $B(x, y)$ denotes the branch metric

$$B(x, y) = 2xy - x^2.$$

In a dicode system, the three noiseless output levels are 1, 0, and -1. A noiseless output of 0 has the trivial branch metric $B(0, y) = 0$, while nonzero noiseless outputs +1 and -1 have branch metrics $B(1, y) = 2y$ - and $B(-1, y) = -2y-1$, respectively.

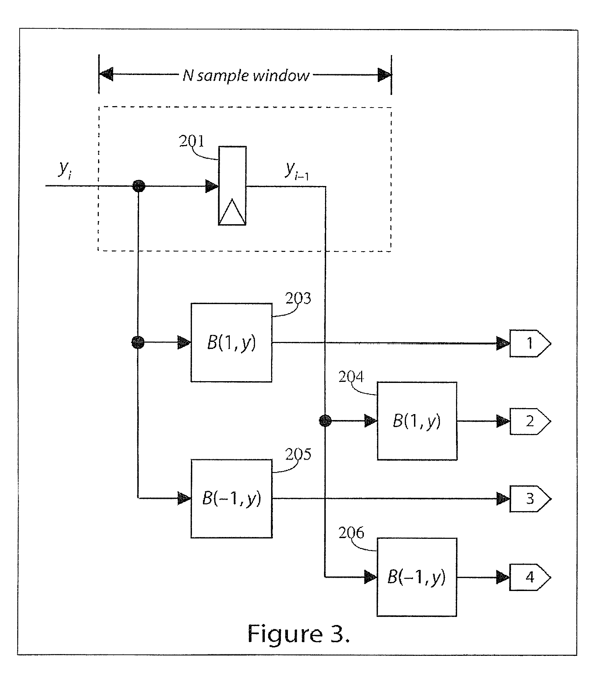

Figure 3 is a diagram of a sample delay line contained in a branch metric generator for an example sliding MAP detector with dicode channels. During the $i^{th}$ operation of the branch metric generator, noisy sample $y_i$ enters the delay line 201, consisting of $(N-1)$ registers. The output of 201 is $y_{i-1}$. Estimation decisions of the example dicode detector are based on the samples in this sliding window.

The branch metric generator contains four branch metric computation units. The branch metric computation units 203, 204, 205 and 206 of Fig. 3 calculate

$$B(1, y_i) = 2y_i - 1, \quad B(1, y_{i-1}) = 2y_{i-1} - 1, \quad B(-1, y_i) = -2y_i - 1\ , \qquad \text{and } B(-1, y_{i-1}) = -2y_{i-1}\text{-1, respectively. Said}$$

four branch metrics are output from the branch metric generator on schematic outputs one through four, respectively.

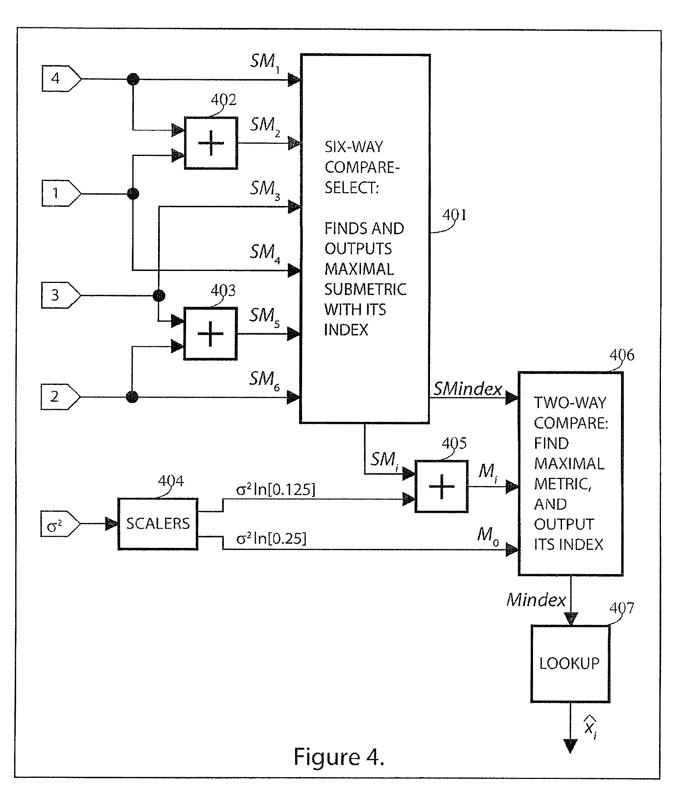

Figure 4 is a decision unit for an example sliding MAP detector for dicode channels. The outputs of the branch metric generator of Fig. 3 are rearranged and combined to produce sub-metrics for hypotheses $H_1$ through $H_6$, denoted $SM_1$ through $SM_6$, respectively. Specifically, sub-metrics $SM_1$, $SM_3$, $SM_4$, and $SM_6$ are available directly as outputs of the branch metric generator, while sub-metrics $SM_2$ and $SM_5$ are obtained as pair-wise sums of outputs the branch metric generator, produced at outputs of adders 402 and 403.

The six sub-metrics are compared in six-way compare-select unit 401, which compares the six sub-metrics to find a maximum sub-metric and its associated index, $SM_{index}$. Said index indicates a most likely hypothesis for a nonzero subsequence with prior probability 0.125.

To compare subsequences with differing prior probabilities, the subsequence sub-metric for hypothesis $H_v$ is offset by $2\sigma^2$ ln [Pr[$v$]] to create a subsequence metric. A scaling unit, unit 404 of Fig. 4, scales the estimated variance by terms ln [0.125] and ln [0.25] to create two offsets for the two prior subsequence probabilities. The sub-metric output of unit 401 is offset in adder 405 to produce a sequence metric for a most likely hypothesis for a nonzero subsequence with prior probability 0.125, while the all-zero subsequence metric is given by $2_6^2$ ln [0.25]. Said metrics are compared to select a maximum metric and its index in two-way compare-select unit 406.

In Fig. 4, the output of 406 is input to lookup table 407, which determines an estimate of $x_i$ as a function of the index of the maximum metric. For example, if the maximum metric has index 3, it is associated with hypothesis $H_3$, and lookup table 407 outputs the hypothetical value of $x_i$ in hypothesis $H_3$, the value -1.

Optionally, lookup table 407 can also provide consistency checking, which is not shown in Fig. 4. In this option, lookup table 407 can also output the hypothetical value of $x_{i-1}$ in recursion $i$. This is an overlapping subsequence from the previous subsequence estimated as the most likely output of the channel in recursion ($i$-1). If there is a mismatch in this estimate, a consistency check circuit can flag a possibly incorrect decision. Partial response receiver control circuit estimators of Fig. 1 can optionally utilize this flag to defeat erroneous channel adjustments.

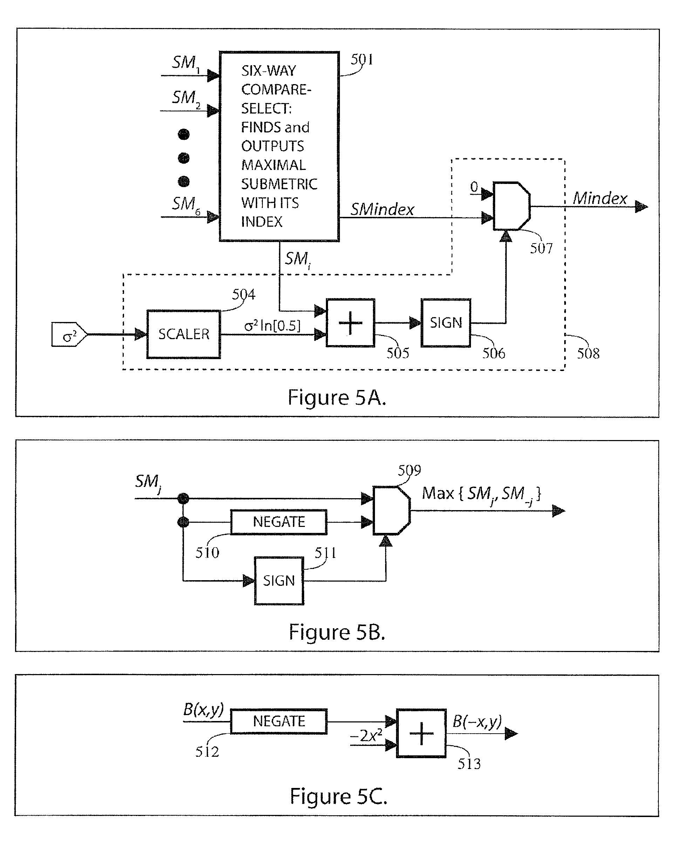

While the detector of Fig. 4 is a direct implementation of the disclosed detector decision rule, various simplifications can be made to further reduce circuit complexity. Several simplifications are illustrated in Figure 5. For these simplifications, a generalized $N$-sample subsequence metric of the form

$$P_v = 2\sigma^2 \ln\left[\Pr[\mathbf{v}]\right] + \sum_{h=1}^{N} B(y_{i-N+h}, v_h)$$

is assumed. If $P_v > P_w$, that is, if

$$2\sigma^2 \ln\left[\Pr[\mathbf{v}]\right] + \sum_{h=1}^{N} B(y_{i-N+h}, v_h) > 2\sigma^2 \ln\left[\Pr[\mathbf{w}]\right] + \sum_{h=1}^{N} B(y_{i-N+h}, w_h),$$

it follows that

$$2\sigma^2 \ln\left[\Pr[\mathbf{v}]/\Pr[\mathbf{w}]\right] + \sum_{h=1}^{N} B(y_{i-N+h}, v_h) > \sum_{h=1}^{N} B(y_{i-N+h}, w_h).$$

The latter expression allows two sequences with differing probabilities to be compared using only one offset factor.

Figure 5A illustrates a simplification of the scaling unit and final two-way compare-select unit of Fig. 4 using said offset factor, contained in a simplified unit 508. Unit 504 multiplies an estimate of the noise variance by a factor to output an offset related to the ratio of prior probabilities,

$$2\sigma^2 \ln[0.125 / 0.25] = 2\sigma^2 \ln[0.5].$$

The offset is added to the sub-metric output of unit 501 in adder 505. If the result is positive, a SIGN unit 506 outputs a logical one. The 506 output serves as a selector input to multiplexer 507, which outputs the index of the maximum metric.

Several simplifications are available if two hypotheses have equal prior probabilities. As stated above, when two subsequences have equal prior probabilities, it suffices to compare sub-metrics consisting of a sum of branch metrics.

Suppose that a hypothetical subsequence is almost the same as another hypothetical subsequence of the same probability, in the sense that they differ in only one noiseless sample value. Here, w is almost the same as

$$\mathbf{v} = \{v_1, v_2, ..., v_N\},$$

where $w_h \neq v_h$ for one index $h$ and $w_i = v_i$ otherwise. It follows that $H_v$ is less likely than $H_w$ if and only if $B(v_j, y_{i-N+j}) < B(w_j, y_{i-N+j})$. It can be shown that the comparison of said branch metrics can be accomplished by a single threshold comparison. Figure 5b illustrates a simplified six-way comparison using this expression. The simplification allows the six-way comparison of unit 401 of Fig. 4 to be implemented as a three-way comparison with three pair-wise threshold pre-comparisons.

Similarly, various symmetries can be exploited to reduce the complexity of the branch and sequence metric generators. Figure 5c, for example, illustrates a means to half the number of branch metric calculator units, which can be replaced by simple offset adders.

In summary, the example sliding map detector for partial response channels

  a. predetermines each possible noiseless output subsequence of the partial response channel and associates each with a hypothesis and known prior probability,

  b. calculates a quantity related to the posterior probability of each hypothetical subsequence based on the last N outputs of the channel, using an estimate of the probability distribution of the channel output given the hypothetical output sequence,

  c. compares the quantities calculated in (b) to find a most likely channel output subsequence and its associated hypothesis,

  d. utilizes various simplifications to allow the comparisons of (c) to be replaced by equivalent comparisons of lesser computational complexity,

  e. outputs an estimate of one of the noiseless samples in the most likely subsequence of (c), and

  f. optionally checks if some portion of the overlapping sequence previously considered most likely is consistent with the currently considered most likely subsequence.

An alternative means of implementing the MAP algorithm for partial response detection is also disclosed. In the alternative means, the metric comparison equations are manipulated to isolate comparisons for a particular sample to be estimated. A detector decision is made by comparing the particular sample to thresholds computed as a function of surrounding noisy samples in the window. Said detector apparatus is denoted a sliding moving threshold detector (MTD).

Specifically, consider a sliding MAP detector decision rule, which chooses between hypotheses $H_v$ and $H_w$ based on a comparison of the posterior probabilities, $P_v$ and $P_w$. With a generalized $N$-sample window metric, a decision rule $P_v > P_W$ is satisfied if and only if

$$2\sigma^2 \ln\left[\Pr[\mathbf{v}]\right] + \sum_{h=1}^{N} B(y_{i-N+h}, v_h) > 2\sigma^2 \ln\left[\Pr[\mathbf{w}]\right] + \sum_{h=1}^{N} B(y_{i-N+h}, w_h).$$

In the $i^{th}$ recursion, the detector outputs $\hat{x}_j$, where $i - N < j < i + 1$. Let $k = N + j - i$.

By rearranging terms and simplifying to isolate a particular $y_j$, it may be shown that the sliding MAP detector decision rule is equivalent to $P_v > P_W$ if and only if

$$\sigma^2 \ln\left[\Pr[\mathbf{v}]/\Pr[\mathbf{w}]\right] + \frac{1}{2}\left\{\left(w_k^2 - v_k^2\right) + \sum_{i-N+h \neq j}\left[B\left(y_{i-N+h}, v_h\right) - B\left(y_{i-N+h}, w_h\right)\right]\right\} > y_j(w_k - v_k)$$

If $w_k \neq v_k$, then $P_v > P_w$ if and only if

$$\left(\frac{v_k + w_k}{2}\right) + \frac{1}{2(w_k - v_k)}\left[2\sigma^2 \ln\left[\Pr[\mathbf{v}]/\Pr[\mathbf{w}]\right] + \left\{\sum_{i-N+h \neq j}\left[B\left(y_{i-N+h}, v_h\right) - B\left(y_{i-N+h}, w_h\right)\right]\right\}\right] > y_j.$$

The sliding MAP detector decision rule is thus shown to be equivalent to setting a moving threshold, which depends on other noisy samples in the sliding window, and deciding between two hypotheses based on a comparison of the particular noisy sample with the moving threshold.

In particular, let $u = v_k$ be an integral noiseless output level of the partial response system, and $u + 1 = w_k$ be the next larger noiseless output level of the system. The decision rule for deciding between subsequences which take on successive levels in the $k^{th}$ sample in the window simplifies to $P_v > P_w$ if and only if

$$\sigma^2 \ln\left[\Pr[\mathbf{v}]/\Pr[\mathbf{w}]\right] + \frac{1}{2}\left[\sum_{h \neq k}B\left(y_{i-N+h}, v_h\right) - \sum_{h \neq k}B\left(y_{i-N+h}, w_h\right)\right] + u + \frac{1}{2} > y_{i-N+k}.$$

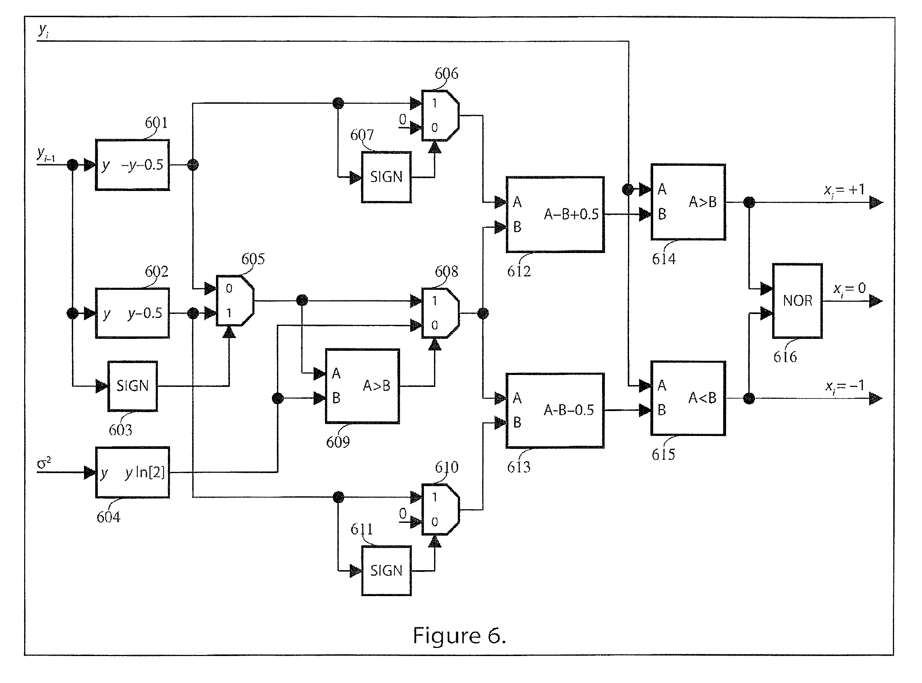

Figure 6 illustrates the implementation of the sliding MTD for the example dicode channel of the present disclosure with N = 2, which utilizes a sliding window of the two most recently observed samples in the $i^{th}$ recursion, $\{y_{i-1}, y_i\}$, to estimate the value of $x_i$.

Initially, the samples in the window excluding $y_i$ are used to determine a most likely subsequence for each possible value of $x_i$. For example, the only two possibilities with $x_i = 1$ are $H_2$ or $H_4$. Comparing the posterior probability of the two equiprobable hypothetical subsequences, $P_2 > P_4$ if and only if $(-y_{i-1} - 0.5)$ is positive. In Fig. 6, computation unit 601 outputs $(-y_{i-1} - 0.5)$, which is input to SIGN unit 607. If $(-y_{i-1} - 0.5)$ is positive, the output of unit 607 is a logical one. The output of 607 is the selector input to multiplexer 606, which outputs $(-y_{i-1} - 0.5)$ if $P_2 > P_4$ and outputs zero otherwise.

Similarly, the only two possibilities with $x_i = -1$ are $H_3$ or $H_5$. Comparing the posterior probability of the two equiprobable hypothetical subsequences, $P_5 > P_3$ if and only if $(y_{i-1} - 0.5)$ is positive. In Fig. 6, computation unit 602 outputs $(y_{i-1} - 0.5)$. The output of multiplexer 610 is $(y_{i-1} - 0.5)$ if $P_5 > P_3$, and zero otherwise.

Two equiprobable sequences with $x_i = 0$ are in hypothesis $H_1$ or $H_6$. Comparing the posterior probability of the two equiprobable hypothetical subsequences, $P_6 > P_1$ if and only if $y_{i-1}$ is positive. SIGN unit 603 outputs a logical one and multiplexer 605 outputs $(y_{i-1} - 0.5)$ if $y_{i-1}$ is positive; otherwise multiplexer 605 outputs $(-y_{i-1} - 0.5)$.

Scaling unit 604 computes a relative metric for the subsequence of hypothesis $H_0$, which is compared with the output of multiplexer 605 in comparator 609. The output of comparator 609 is a selector input of multiplexer 608, which outputs a metric for the most likely subsequence with $x_i = 0$.

The three subsequence metrics at the outputs of multiplexers 606, 608 and 610 are metrics of most likely subsequences ending in all possible levels for $x_i$. The three relative metrics are combined in computation units 612 and 613 to set two thresholds for $y_i$. Computation unit 612 sets the midpoint for a comparison to decide between $(x_i = 0)$ and $(x_i = 1)$. Comparator 614 outputs a logical one if $(x_i = 1)$ is more likely. Similarly, computation unit 613 sets the midpoint for a comparison to decide between $(x_i = 0)$ and $(x_i = -1)$. Comparator 615 outputs a logical one if $(x_i = -1)$ is more likely. NOR gate 616 outputs a logical one if $(x_i = 0)$ is the most likely.

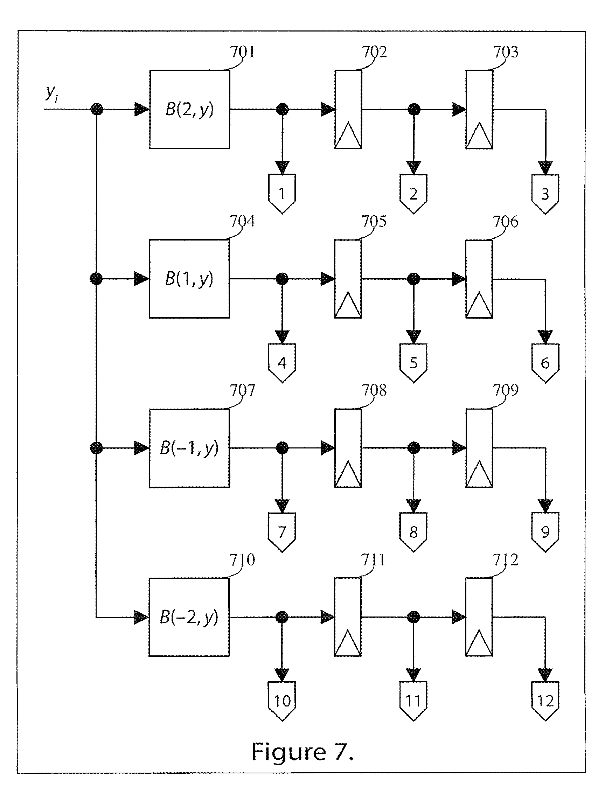

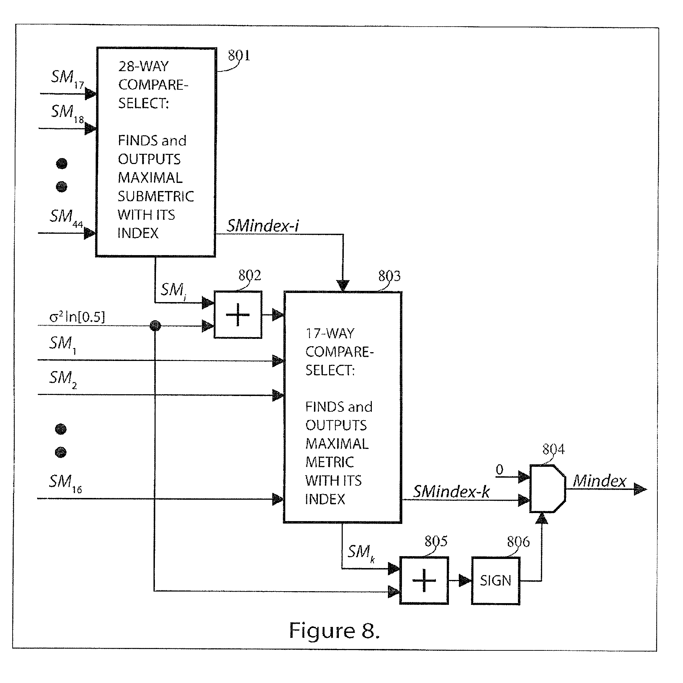

An example embodiment of the present invention for EPR4 channels is shown in Figures 7 and 8. The preferred sliding map detector for EPR4 channels of the present invention utilizes a sliding window of the three most recently observed samples $\{y_{i-2}, y_{i-1}, y_i\}$. Decisions are based on all of the samples in the window.

Table 1 lists all 45 possible noiseless subsequences of length three at the output of an EPR4 channel with random binary inputs. Each sequence is listed with a hypothesis index, a series of three noiseless samples, and a prior subsequence probability. Table 1 is split into three equiprobable groups. Table 1A contains only the all-zero subsequence, with prior probability 1/16. Table 1B contains all 16 subsequences of length 3 with prior probability 1/32. Table 1C contains all 28 subsequences of length 3 with prior probability 1/64.

A noiseless EPR4 channel with binary inputs has the property that the output takes on five distinct values, -2, -1, 0, 1, and 2. Figure 7 illustrates the branch metric generator for EPR4 with a three-sample window. Branch metric computation units 701, 704, 707, and 710 compute branch metrics for each of the nonzero noiseless output values, computing $B(2,y)=4y-4$, $B(1,y)=2y-1$, $B(-1,y)=-2y-1$ and $B(-2,y)=-4y-4$, respectively. Delay lines 702-703, 705-706, 708-709, and 711-712 provide delayed branch metrics. The outputs of the branch metric generator are labeled 1 through 12.

The sub-metrics are calculated by adding various branch metrics at the output of the branch metric generator. For example, hypothesis 37, with noiseless sample values $\{x_{i-2}, x_{i-1}, x_i\} = \{2,1,-1\}$ has associated sub-metric

$$SM_{37} = B(2, y_{i-2}) + B(1, y_{i-1}) + B(-1, y_i).$$

The three component branch metrics are available at outputs numbered 3, 5, and 7 of Fig. 7. The adders for computing the 45 sub-metrics are not shown.

Figure 8 illustrates the decision unit of the EPR4 sliding map detector. Computation unit 801 is a 28-way compare-select unit, which compares the sub-metrics for hypotheses indexed from 17 to 44, chooses a maximal sub-metric, and outputs said sub-metric and its associated index. Adder 802 provides an offset to compare this most likely output sequence from Table 1C with the output sequences of Table 1B.

Computation unit 803 is a 17-way compare-select unit, which compares the sub-metrics for hypotheses indexed from 1 to 16 and the most likely hypothesis from Table 1C. Unit 803 chooses a maximal metric, and outputs said metric and its associated index. Adder 805 provides an offset to compare this most likely output sequence from Tables 1B and 1C with the output sequence of Table 1A. The final simplified two-way compare select is the same as that shown in Figure 5A. The remainder of the detector consists of a lookup table (not shown), performing the same operation as lookup table 407, and consistency checking logic (not shown).

Table 1. Noiseless EPR4 subsequences

The following Table is grouped into three subgroups according to prior probability:

Table 1A. Noiseless EPR4 subsequences with prior probability 0.0625

| Index | x[i] | x[i-1] | x[i-2] |
|---|---|---|---|
| probability | | | |
| 0 | 0 | 0 | 0 |
| 0.062500 | | | |

Table 1B. Noiseless EPR4 subsequences with prior probability 0.03125

| index | x[i] | x [i-1] | x [i-2] |
|---|---|---|---|
| probability | | | |
| 1 | -1 | 0 | 0 |
| 0.031250 | | | |
| 2 | -1 | -1 | 0 |
| 0.031250 | | | |
| 3 | 1 | -1 | -1 |
| 0.031250 | | | |
| 4 | 0 | -1 | -1 |
| 0.031250 | | | |

| | (continued) | | |
| --- | --- | --- | --- |
| index | x[i] | x [i-1] | x [i-2] |
| probability | | | |
| 5 | 1 | 1 | -1 |
| 0.031250 | | | |
| 6 | 0 | 0 | -1 |
| 0.031250 | | | |
| 7 | 0 | 1 | 1 |
| 0.031250 | | | |
| 8 | -1 | 1 | 1 |
| 0.031250 | | | |
| 9 | -1 | 0 | 1 |
| 0.031250 | | | |
| 10 | 1 | 0 | 0 |
| 0.031250 | | | |
| 11 | 0 | -1 | 0 |
| 0.031250 | | | |
| 12 | 0 | 1 | 0 |
| 0.031250 | | | |
| 13 | 1 | 0 | -1 |
| 0.031250 | | | |
| 14 | 0 | 0 | 1 |
| 0.031250 | | | |
| 15 | -1 | -1 | 1 |
| 0.031250 | | | |
| 16 | 1 | 1 | 0 |
| 0.031250 | | | |

Table 1C. Noiseless EPR4 subsequences with prior probability 0.015625

| index | x[i] | x[i-1] | x[i-2] |
| --- | --- | --- | --- |
| probability | | | |
| 17 | -2 | -1 | 0 |
| 0.015625 | | | |
| 18 | 0 | -2 | -1 |
| 0.015625 | | | |
| 19 | -1 | -2 | -1 |
| 0.015625 | | | |
| 20 | 0 | 1 | -1 |
| 0.015625 | | | |
| 21 | -1 | 0 | -1 |
| 0.015625 | | | |
| 22 | 2 | 0 | -2 |
| 0.015625 | | | |
| 23 | 1 | 0 | -2 |
| 0.015625 | | | |
| 24 | 1 | -1 | -2 |
| 0.015625 | | | |
| 25 | 0 | -1 | -2 |
| 0.015625 | | | |
| 26 | -2 | 0 | 1 |

(continued)

| index | x[i] | x[i-1] | x[i-2] |
|---|---|---|---|
| probability | | | |
| 0.015625 | | | |
| 27 | 1 | 2 | 0 |
| 0.015625 | | | |
| 28 | 0 | 2 | 0 |
| 0.015625 | | | |
| 29 | -1 | 1 | 0 |
| 0.015625 | | | |
| 30 | 2 | 1 | -1 |
| 0.015625 | | | |
| 31 | -2 | -1 | 1 |
| 0.015625 | | | |
| 32 | 1 | -1 | 0 |
| 0.015625 | | | |
| 33 | 0 | -2 | 0 |
| 0.015625 | | | |
| 34 | -1 | -2 | 0 |
| 0.015625 | | | |
| 35 | 2 | 0 | -1 |
| 0.015625 | | | |
| 36 | 0 | 1 | 2 |
| 0.015625 | | | |
| 37 | -1 | 1 | 2 |
| 0.015625 | | | |
| 38 | -1 | 0 | 2 |
| 0.015625 | | | |
| 39 | -2 | 0 | 2 |
| 0.015625 | | | |
| 40 | 1 | 0 | 1 |
| 0.015625 | | | |
| 41 | 0 | -1 | 1 |
| 0.015625 | | | |
| 42 | 1 | 2 | 1 |
| 0.015625 | | | |
| 43 | 0 | 2 | 1 |
| 0.015625 | | | |
| 44 | 2 | 1 | 0 |
| 0.015625 | | | |

While a number of exemplary aspects and embodiments have been discussed above, those of skill in the art will recognize certain modifications, permutations, additions and sub-combinations thereof. It is therefore intended that the following appended claims and claims hereafter introduced are interpreted to include all such modifications, permutations, additions and sub-combinations as are within their true spirit and scope; the scope of the invention being defined by the appended claims.

**Claims**

1. A method to recursively estimate a noiseless output of a noisy partial response channel, the method comprising:

   accessing a window of N most recent samples of a noisy channel output, wherein N is greater than one;

using a set of all possible sequences of the N most recent noiseless outputs of the partial response channel and a prior probability of each such possible sequence;

processing the set of all possible sequences of the N most recent noiseless outputs of the partial response channel by:

determining a metric to associate with each member of the set of all such possible sequences;
comparing the determined metrics and selecting a maximal metric;
determining the particular member of the set of all possible sequences associated with the maximal metric; and

outputting an estimate for a select sample in the window of N most recent samples based on the corresponding noiseless channel output in the particular sequence of N noiseless channel outputs with the maximal metric.

2. The method of claim 1 wherein the metric associated with a window of noisy samples $\{y_{i\text{-}N+1}, y_{i\text{-}N+2}, ..., y_i\}$ and a possible noiseless sequence $(v_1, v_2, ..., v_N)$ with a prior sequence probability p is the sum of a sub-metric and a probability offset term.

3. The method of claim 2 wherein the probability offset term is proportional to the product of an estimated noise variance, $\sigma^2$, and the natural logarithm of the prior sequence probability, p.

4. The method of claim 2 wherein the sub-metric is a summation consisting of a sum of N branch metric terms, the summation is taken over the N terms where J = 1, 2, ..., N, x is the $J^{th}$ indexed noiseless sample, $v_J$, y is the corresponding $J^{th}$ indexed noisy sample in the window, $y_{i\text{-}N+J}$, and the $J^{th}$ branch metric term is

$$(x - y)^2.$$

5. The method of claim 2 wherein the comparison of determined metrics for two sequences with equal prior sequence probabilities is simplified by comparing sub-metrics for the two sequences.

6. The method of claim 2 wherein the comparison of determined metrics for two sequences with unequal prior sequence probabilities, $p_1$ and $p_2$, is simplified by comparing the sub-metric for the first sequence to a sum for the second sequence, where the sum is the sub-metric for the second sequence plus a relative probability offset term, said relative probability offset term equal to the product of an estimated noise variance, $\sigma^2$, and the natural logarithm of the ratio of the prior sequence probabilities, $p_2 / p_1$.

7. The method of claim 4 wherein the comparison of determined metrics for two sequences with a common $K^{th}$ indexed sample value, $v_K$, is simplified by modifying the sub-metric summation to eliminate the $K^{th}$ indexed branch metric term from the summation.

8. The method according to any one of the preceding claims wherein the set of all possible sequences of the N most recent noiseless outputs of the partial response channel is partitioned into two or more subsets and each member sequence in a particular subset has the same prior probability.

9. The method according to any one of the preceding claims wherein the partial response channel is an extended class-IV partial response (EPR4) channel.

10. The method of claim 1 wherein the window size is N, said N equal to three or five.

11. An apparatus to sequentially estimate a noiseless output of a noisy partial response channel, the apparatus comprising:

a memory operative to store noisy outputs of a partial response channel and
a logic circuit operative to:

access the memory to obtain the N most recent samples of noisy channel output;

use a set of all possible sequences of the N most recent noiseless outputs of the partial response channel and a prior probability of each such possible sequence;
process the set of all possible sequences of the N most recent noiseless outputs of the partial response channel by using circuitry operative to:

determine a metric to associate with each member of the set of all such possible sequences;
compare the determined metrics and select a maximal metric;
determine the particular member of the set of all possible sequences associated with the maximal metric; and

output an estimate for a select sample in the window of N most recent samples based on the corresponding noiseless channel output in the particular sequence of N noiseless channel outputs with the maximal metric.

12. The apparatus of claim 11, wherein the memory is an N-stage shift register and each stage of the shift register consists of a plurality, m, of single-bit registers when each noisy sample value is quantized to m bits.

13. The apparatus of claim 11, wherein the metric associated with a window of noisy samples $\{y_{i-N+1}, y_{i-N+2}, ..., y_i\}$ and a possible noiseless sequence $(v_1, v_2, ..., v_N)$ with a prior sequence probability p is the output of an adder circuit which adds a sub-metric to a probability offset term; preferably
an adder is operative to output the sub-metric equal to a sum of branch metric terms; preferably
a branch metric term calculation unit is operative to output the branch metric term for a noiseless sample, x, and a corresponding noisy sample, y, equal to

$$x^2 - 2\,x\,y.$$

14. The apparatus according to any one of the claims 11 to 13, wherein a comparator output is operative to indicate which of two metrics is a maximal metric; preferably
the comparator output is connected to a selector input of a multiplexer, said multiplexer operative to select the maximal metric and a sequence index number of an associated sequence index; preferably
the associated sequence index is connected to address a memory of estimated sample values indexed by noiseless sequence number, said memory operative to output an estimated sample value of the sequence with maximal metric; preferably
said memory is further operative to output one or more other noiseless sample values, in addition to the estimated noiseless sample value, of the sequence with maximal metric; preferably
one or more comparators further operative to compare the estimated sample value for the current recursion with the corresponding one or more other sample values output from the memory of estimated samples in one or more other recursions, to output an inconsistency indicator indicating a mismatch.

15. A method to recursively estimate a noiseless output of a noisy partial response channel, the method comprising:

accessing a window of N most recent samples of a noisy channel output, wherein N is greater than one;
using a set of all possible noiseless output values of the partial response channel;
processing each particular noiseless value in the set of all possible noiseless output values by:

using a set of all possible sequences of the N most recent noiseless outputs of the partial response channel taking on the particular value in a particular location within the window, and a prior probability of each such possible sequence;
determining a sub-metric associated with each member of the set;
comparing the determined sub-metrics and selecting a maximal sub-metric; and
associating the maximal sub-metric with the particular noiseless output value; and processing each pair of particular noiseless values in the set of all possible noiseless output values of the partial response channel by:
determining a threshold;
comparing the noisy output sample in the particular location within the window to the threshold;

using the comparison to select an output value in the pair of particular noiseless values; and

determining an output estimate using the outputs of the pair-wise comparisons; preferably the partial response channel is an extended class-IV partial response (EPR4) channel; and/or preferably the window size is N, said N equal to three or five.

Figure 1.

Figure 2.

Figure 3.

Figure 4.

$SM_1$

$SM_2$

$SM_6$

SIX-WAY COMPARE-SELECT: FINDS and OUTPUTS MAXIMAL SUBMETRIC WITH ITS INDEX

501

0

507

$SMindex$

$Mindex$

$SM_i$

504

SCALER

$\sigma^2$

$\sigma^2 \ln[0.5]$

+

505

SIGN

506

508

Figure 5A.

$SM_j$

509

NEGATE

Max { $SM_j$, $SM_{-j}$ }

510

511

SIGN

Figure 5B.

$B(x,y)$

NEGATE

512

$-2x^2$

+

$B(-x,y)$

513

Figure 5C.

20

Figure 6.

Figure 7.

Figure 8.

Europäisches
Patentamt

European
Patent Office

Office européen
des brevets

**EUROPEAN SEARCH REPORT**

Application Number

EP 08 15 8167

**DOCUMENTS CONSIDERED TO BE RELEVANT**

| Category | Citation of document with indication, where appropriate, of relevant passages | Relevant to claim | CLASSIFICATION OF THE APPLICATION (IPC) |
|---|---|---|---|
| X | T.K. MOON: "Error Correction Coding" 2005, WILEY-INTERSCIENCE , XP002500723 * page 469 - page 486 * * page 472, line 17 - line 21 * ----- | 1-15 | INV. H03M13/39 |

TECHNICAL FIELDS
SEARCHED      (IPC)

H03M

The present search report has been drawn up for all claims

| Place of search | Date of completion of the search | Examiner |
|---|---|---|
| The Hague | 22 October 2008 | Van Staveren, Martin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **CARL W. HELSTROM.** Probability and Stochastic Processes for Engineers. Macmillan Publishing Company, 1984, 50-51

- **CARL W. HELSTROM.** Probability and Stochastic Processes for Engineers. Macmillan Publishing Company, 1984, 136